# EUROPÄISCHE PATENTANMELDUNG

(11) **EP 0 864 877 A1**
(43) Veröffentlichungstag der Anmeldung: **16.09.1998**
(21) Anmeldenummer: 97104064.7
(22) Anmeldetag: 11.03.1997
(51) Int. Cl.: G01R 31/36, H02J 7/10

(54) **Verfahren und Vorrichtung zum Laden bzw. Entladen eines Akkus mit im Wesentlichen unbestimmter Bauart und/oder Kapazität für eine elektrische oder elektronische Einrichtung**

(71) Anmelder: SIEMENS AKTIENGESELLSCHAFT, 80333 München (DE)
(72) Erfinder: Ludger, Kruse, 46399 Bocholt (DE)

(57) **Zusammenfassung**

Eine Vorrichtung und ein Verfahren zum Laden bzw. Entladen eines Akkus (1, 2) mit im wesentlichen unbestimmter Bauart und/oder Kapazität für eine elektrische oder elektronische Einrichtung, wobei der Akku (1, 2) anfänglich mit Sicherheit vollgeladen wird und sodann durch den Betrieb der elektrischen oder elektronischen Einrichtung, unter Verhinderung eines Nachladens, entladen wird, bis ein unterer Grenzwert für die Akkuladung (LowBatt) erreicht wird, wobei während dieses Entladens durch ein Mittel zum Bestimmen der entladenen Ladungsmenge (C-Count, C-Count) jene Ladungsmenge bestimmt wird, welche aus dem Akku entnommen wurde und der Wert für die aktuelle maximale Akkukapazität (MaxCapacity) des Ladealgorithmus auf diesen bestimmten Wert gesetzt wird. Dadurch kann die tatsächlich vorhandene Akkukapazität durch den Ladealgorithmus selbsttätig ermittelt und gegebenenfalls aktualisiert werden.

## Beschreibung

Die vorliegende Erfindung bezieht sich auf ein Verfahren und eine Vorrichtung zum Laden bzw. Entladen eines Akkus mit im wesentlichen unbestimmter Bauart und/oder Kapazität für eine elektrische oder elektronische Einrichtung.

Bei Verwendung eines oder mehrerer Akkus mit unbestimmter Bauart oder Kapazitat werden beim Ladevorgang üblicherweise schwächere Akkus beschädigt oder zerstört und stärkere Akkus ungenügend ausgenutzt. Demnach wird ein Benutzer vom Hersteller eines elektrischen oder elektronischen Gerätes angewiesen, für ein bestimmtes Gerät, z.B. ein Mobilfunktelefon, einen bestimmten Akku zu verwenden. Alternativ besteht die Möglichkeit, daß der Benutzer dem Ladealgorithmus die Nennkapazität des verwendeten Akkus manuell eingibt. Diese Lösung ist jedoch für den Benutzer unbefriedigend, da sie die Handhabung des Gerätes erschwert. Ferner kann es vorkommen, daß der Benutzer die Eingabe der Nennkapazität vergißt oder versehentlich eine falsche Nennkapazität eingibt, sodaß es zu einer ungenügenden Ausnutzung oder einer Zerstörung des Akkus kommen kann.

Die vom Hersteller angegebene Nennkapazität kann während der Lebensdauer eines Akkus erheblichen Schwankungen unterliegen, die zu einer ungenugenden Nutzung der Akkukapazität oder zu einer Beschädigung und folglich einer Verringerung der Lebensdauer eines Akkus fuhren kann. Ferner ist durch die Abweichung zwischen Soll- und Istkapazität eine Toleranz der Batterieanzeigefunktion verbunden, welche folglich mit zunehmender Lebensdauer des Akkus vergrößert wird. Ein nahezu vollgeladener Akku soll in der sogenannten Nachlade- bzw. Erhaltungsladephase in Abhängigkeit von der Gesamtkapazität mit einem verringerten Ladestrom geladen werden, um eine hohe Lebensdauer zu erzielen. Falls Ist- und Sollkapazität nicht übereinstimmen, sind demnach auch die vorprogrammierten Ladeströme für das Nach- bzw. Erhaltungsladen ungenau.

Es ist daher eine Aufgabe der vorliegenden Erfindung, eine Möglichkeit zur Mischbestückung von Akkus zu schaffen, bei welcher ohne Zutun des Benutzers auf die tatsachliche Akkukapazität Rücksicht genommen wird, um sowohl die Kapazität als auch die Lebensdauer eines Akkus optimal auszunutzen.

Diese Aufgabe wird bei einer elektrischen oder elektronischen Einrichtung, bei welcher ein Mittel zum Anzeigen eines unteren Grenzwertes der Akkuladung und ein Mittel zum Bestimmen einer geladenen oder entladenen Ladungsmenge vorgesehen ist, mit einem Verfahren gelöst, welchem eine gerätspezifische Nennkapazität zugrunde gelegt ist und welches die folgenden Schritte aufweist:
a) Laden des Akkus für eine vorbestimmte Zeitdauer, nach welcher in Abhängigkeit von der Nennkapazität und einem vorgegebenen Ladestrom der Akku im wesentlichen vollständig aufgeladen ist,
b) Nachladen des Akkus für eine bestimmte Zeitdauer mit einem gegebenenfalls verringerten Ladestrom, bei welchem eine Zerstörung eines vollgeladenen Akkus vermieden und ein Volladen eines nicht gänzlich vollgeladenen Akkus sichergestellt wird,
c) Entladen des Akkus durch den Betrieb der elektrischen oder elektronischen Einrichtung unter Verhinderung eines Nachladens, bis der untere Grenzwert der Akkuladung erreicht wird, wobei während dieses Entladens durch das Mittel zum Bestimmen der entladenen Ladungsmenge jene Ladungsmenge bestimmt wird, welche aus dem Akku entnommen wurde,
d) Setzen des Wertes der aktuellen maximalen Akkukapazität auf den durch das Mittel zum Bestimmen der entladenen Ladungsmenge bestimmten Wert.

Durch dieses Verfahren ist es nun möglich, unabhängig von der tatsächlich vorliegenden Akkukapazität ausgehend von einer Nennkapazität in einem Zyklus durch sanftes Volladen und Entladen des Akkus bis auf seine untere Grenze die tatsächliche Kapazität zu ermitteln, welche in der Folge dem Ladealgorithmus zugrunde gelegt wird. Somit kann der Benutzer in einfacher Weise beliebige Akkus verwenden und diese beliebig miteinander kombinieren, da sich das Gerät durch den erfindungsgemäßen Zyklus automatisch an die tatsächliche Kapazität anpaßt.

Eine besonders eingerichtete Vorrichtung zur Durchführung des obigen Verfahrens ist dadurch gekennzeichnet, daß sie ein Mittel zum Laden des Akkus für eine vorbestimmte Zeitdauer, nach welcher in Abhängigkeit von der Nennkapazität und einem vorgegebenen Ladestrom der Akku im wesentlichen vollständig aufgeladen ist, ein Mittel zum Nachladen des Akkus für eine vorbestimmte Zeitdauer mit einem gegebenenfalls verringerten Ladestrom, bei welchem eine Zerstörung eines vollgeladenen Akkus vermieden und ein Volladen eines nicht gänzlich vollgeladenen Akkus sichergestellt ist, ein Mittel zum Verhindern eines Nachladens des Akkus bei Entladen des Akkus durch den Betrieb der elektrischen oder elektronischen Einrichtung bis auf den unteren Grenzwert für die Akkuladung, sowie ein Mittel zum Bestimmen der dabei entladenen Ladungsmenge und ein Mittel zum Setzen eines Wertes für die aktuelle maximale Akkukapazität auf den durch das Mittel zum Bestimmen der entladenen Ladungsmenge bestimmten Wert aufweist.

In vorteilhafter Weise wird der obige Zyklus mit den Schritten a), b), c) und d) nur bei einem erstmaligen Laden bzw. Entladen des Akkus durchgeführt. Bei einem nachfolgenden Laden und Entladen des Akkus wird die geladene bzw. entladene Ladungsmenge durch das Mittel zum Bestimmen der Ladungsmenge ermittelt und der aktuellen Ladungsmenge addiert bzw. subtrahiert, wobei für den Fall, daß bei Erreichen des unteren Grenzwertes die durch das Mittel zum Bestimmen der entladenen Ladungsmenge ermittelte Summe ungleich Null ist, der Wert für die aktuelle maximale Akkukapazität des Akkus entsprechend neu festgesetzt wird. Demnach ist der Zyklus mit Volladen und vollständigem Entladen des Akkus nur bei dem erstmaligen Laden bzw. Entladen des Akkus notwendig und die Schwankungen der Akkukapazität wahrend des Betriebes werden durch die laufende Bestimmung der geladenen bzw. entladenen Ladungsmenge durchgeführt. Sobald die untere Grenze für die Akkuladung erreicht wird, erkennt der Ladealgorithmus selbsttätig die aktuelle maximale Akkukapazität und kann diese in der Folge optimal nutzen.

Zu diesem Zweck ist bei der erfindungsgemäßen Vorrichtung ein Mittel zum Bestimmen der bei Aufladung des Akkus geladenen Ladungsmenge vorgesehen, welches ein Mittel zur Erfassung des Ladestromes und der Ladezeit umfaßt. Das Mittel zum Bestimmen der bei Entladen des Akkus entladenen Ladungsmenge umfaßt ein Mittel zum Erfassen des aktuellen Betriebszustandes, sowie des daraus resultierenden Stromverbrauchs und der Entladezeit.

Eine für elektronische Einrichtungen in der Praxis besonders vorteilhafte Ausführungsvariante ergibt sich dadurch, daß das Mittel zum Bestimmen der geladenen bzw. entladenen Ladungsmenge einen digitalen Zähler aufweist, welcher in zeitlichen Abständen in Abhängigkeit von dem Ladestrom bzw. dem Entladestrom inkrementiert oder dekrementiert wird. Diese Lösung zeichnet sich vor allem durch einen geringen Hardwareaufwand aus. Der jeweilige Entladestrom kann in diesem Fall aus Betriebsparametern der elektronischen Einrichtung und einer diesen Betriebsparametern zugeordneten Entladestrom-Tabelle ermittelt werden.

Der Zähler wird nun bei Entladen des vollgeladenen Akkus von einem der maximalen Akkukapazität entsprechenden Zählerstand dekrementiert. Für den Fall, daß der Zähler bei Erreichen des unteren Grenzwertes für die Akkuladung noch nicht den Wert Null erreicht hat, wird die dem verbleibenden Zählerstand entsprechende Ladungsmenge von der maximalen Akkukapazität subtrahiert und die resultierende Kapazität als aktuelle maximale Akkukapazität festgelegt. Für den Fall, daß der Zähler jedoch bereits den Wert Null erreicht hat, noch bevor der untere Grenzwert für die Akkuladung erreicht ist, wird ein zweiter Zähler gestartet, welcher in zeitlichen Abständen in Abhängigkeit von der entladenen Ladungsmenge inkrementiert wird, bis der untere Grenzwert für die Akkuladung erreicht ist. Danach kann die dem Zählerstand des zweiten Zählers entsprechende Ladungsmenge zu der maximalen Akkukapazität addiert und der resultierende Kapazitätswert als aktuelle maximale Akkukapazität festgelegt werden. Dadurch kann eine dynamische Anpassung der maximalen Akkukapazität automatisch im laufenden Betrieb der elektronischen Einrichtung erfolgen, ohne daß die Nutzungsmöglichkeiten der Einrichtung beeinträchtigt werden.

Bei Verwendung eines digitalen Zählers ist es von Vorteil, wenn bei jeder Neufestsetzung der maximalen Akkukapazität, die für einen De- bzw. Inkrementierschritt des Zählers erforderliche Ladungsmenge in der Weise neu festgesetzt wird, daß die aktuelle maximale Akkukapazität dem Höchststand des Zählers entspricht. In diesem Fall wird der Zählbereich des Zählers in vorteilhafter Weise nicht durch die Änderung der maximalen Akkukapazität beeinflußt, sodaß die Kapazitätsbestimmung stets mit maximal möglicher Genauigkeit durchgeführt werden kann.

Um die Genauigkeit der Kapazitätsbestimmung weiter zu verbessern, ist bei einer weiteren Ausführungsvariante des erfindungsgemäßen Verfahrens vorgesehen, daß für den Zeitraum nach Ausführen der oben angeführten Schritte a) und b) und vor Beginn des Schrittes c) des Verfahrens ein Erhaltungsladen des Akkus zum Ausgleich seiner ständigen Ladungsverluste, z.B. durch Stand-By Betrieb, vorgenommen wird.

Für derzeit am Markt befindliche Akkus hat es sich als Vorteilhaft herausgestellt, wenn der Akku bei einer Ladung zwischen 0 und ca. 95% der maximalen Akkukapazität mit einem Ladestrom geladen wird, welcher kleiner oder gleich I = 0,1 C beträgt, wobei C die Nennkapazität des Akkus in [Ah] ist und der Strom I in [A] angegeben ist. Bei einer Ladung über ca. 95 % der maximalen Akkukapazität wird hingegen mit einem Ladestrom geladen, welcher kleiner oder gleich I = 0,05 C beträgt.

Eine zuverlässige Bestimmung des unteren Grenzwertes für die Akkuladung kann dadurch erreicht werden, daß die zeitliche Änderung der am Akku anliegenden elektrischen Spannung und/oder die zeitliche Änderung dieser zeitlichen Änderung bestimmt und mit einem jeweils maximal zulässigen Wert verglichen wird. Zusätzlich kann ein unterer Grenzwert der Akkuladung herangezogen werden.

Um mögliche Toleranzen der Kapazitätsbestimmung, z.B. Ungenauigkeiten bei der Inkrementierung oder Dekrementierung des Zählers auszugleichen, kann bei einer Ausführungsvariante des erfindungsgemäßen Verfahrens vorgesehen sein, daß die Verfahrensschritte a), b), c) und d) selbsttätig zur Bestimmung der maximalen Akkukapazität nach einer bestimmten Anzahl von Aufladungen des Akkus oder in zeitlichen Abständen wiederholt werden. Falls der Akku aus der elektrischen oder elektronischen Einrichtung herausgenommen wird, kann ebenso eine Neufestsetzung der Akkukapazität durch Ausführen der Schritte a), b), c) und d) vorgenommen werden, da die Möglichkeit besteht, daß der Benutzer einen anderen Akku mit einer unterschiedlichen Kapazität eingesetzt hat. In diesem Fall wird der Akku sofort auf seine maximale Kapazität geprüft und der Ladealgorithmus an diese geänderte maximale Kapazität angepaßt. Andernfalls wird eine Anpassung der Akkukapazität ebenso vorgenommen, jedoch nur dann, wenn die untere Grenze der Akkuladung erreicht wird, z.B. wenn der Zähler bereits den Wert Null erreicht hat und die Anzeige für den unteren Grenzwert noch nicht angesprochen hat oder wenn die Anzeige bereits angesprochen hat und der Zähler noch auf einem Wert größer Null steht.

Der Hersteller kann bei einer weiteren Ausführungsvariante des Verfahrens weiters vorsehen, daß die Verfahrensschritte a), b), c) und d) nach einer Anforderung zur Bestimmung der maximalen Akkukapazität durch den Benutzer durchgeführt werden.

Anstelle eines Akkus kann das erfindungsgemäße Verfahren ebenso vorteilhaft bei einer Serienschaltung von zumindest zwei handelsüblichen Akkus mit gleichen oder unterschiedlichen Nennkapazitäten eingesetzt werden, da bei solchen Serienschaltungen bereits die Herstellungstoleranzen einen wesentlichen Einfluß auf die maximale Gesamtkapazität ausüben können.

Im folgenden wird die vorliegende Erfindung anhand eines nicht einschränkenden Ausführungsbeispiels näher erläutert, wobei auf die beiliegenden Figuren Bezug genommen wird, welche folgendes zeigen:
Figur 1 eine erfindungsgemäße Vorrichtung zum Laden einer Serienschaltung von zwei Akkus in einem Blockschaltbild,
Figuren 2a und 2b ein Ablaufdiagramm für das erfindungsgemäße Verfahren bei erstmaligem Laden (Fig. 2a) und Entladen (Fig. 2b)der Akkus von Figur 1 und
Figuren 3a und 3b Entladungszeitdiagramme zur Bestimmung der aktuellen maximalen Kapazität der Akkus.

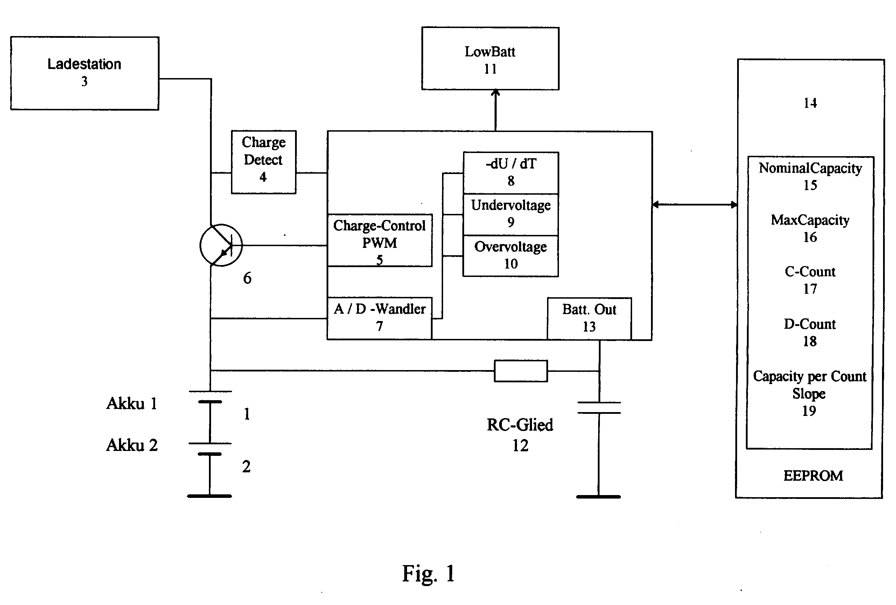

Vorerst wird auf die Figur 1 Bezug genommen, in welcher eine Vorrichtung der erfindungsgemäßen Art zum Laden und Entladen von zwei in Serie geschalteten Akkus 1, 2 einer nicht näher dargestellten elektronischen Einrichtung, z.B. ein Mobilfunktelefon, dargestellt ist, welches an eine Ladestation 3 angeschlossen werden kann. Mit Ausnahme der Ladestation 3 ist bei dem gezeigten Ausführungsbeispiel die gesamte Vorrichtung in die elektronische Einrichtung integriert, da sie sowohl zur Steuerung des Lade- als auch des Entladevorganges dient. Die Ladestation, z.B. eine Ladeschale eines Mobilfunktelefons, umfaßt im wesentlichen eine handelsübliche Gleichstromquelle, die beispielsweise aus einem Netz gespeist wird und sekundärseitig einen Konstantstrom liefert.

Die Vorrichtung umfaßt zur Steuerung des Ablaufs des Lade- bzw. Entladealgorithmus einen der Einfachheit halber nicht näher dargestellten Mikrorechner mit einem Prozessor und den üblichen Komponenten einer Mikrorechnerarchitektur, wie z.B. ein Bus, Speicherbänke, Taktgeber, UART u.dgl., von welchen in Figur 1 lediglich ein für bestimmte Register des Algorithmus reservierter Teilabschnitt eines EEPROM's und der Daten-Bus dargestellt sind.

Die Vorrichtung umfaßt weiters eine mit Charge Detect bezeichnete Einheit 4, durch welche festgestellt werden kann, ob die elektronische Einrichtung an die Ladestation 3 angeschlossen ist, um den Ladealgorithmus zu aktivieren. Der von dem Algorithmus vorgegebene Ladestrom wird mittels einer mit Charge Control PWM bezeichneten Einheit 5 geregelt, welche zu diesem Zweck über Pulsweitenmodulation einen Halbleiterschalter 6 ansteuert.

Zur Bestimmung der an den Akkus 1, 2 anliegenden Spannung ist ein Analog/Digitalwandler 7 vorgesehen, welcher aus der gemessenen Spannung ein digitales Signal erzeugt und dieses zur weiteren Verarbeitung bestimmten Einheiten der Vorrichtung bereitstellt, nämlich einer Einheit 8 zum Bestimmen der zeitlichen Änderung der Spannung -dU/dt, einer Einheit 9 zum Überwachen eines unteren Grenzwertes für die Spannung und einer Einheit 10 zum Überwachen einer Überspannung. Im Rahmen der vorliegenden Erfindung sind besonders die Einheiten 8 und 9 bedeutsam, da diese bei Entladen des Akkus zur Signalisierung eines unteren Grenzwertes für die Akkuladung durch die mit LowBatt bezeichnete Einheit 11 vorgesehen sind, z.B. an einem Display eines Mobilfunktelefons. Die Anzeige für Low-Batt wird nämlich dann aktiviert, wenn entweder der ermittelte Wert für die Änderung der Akkuspannung -dU/dt einen bestimmten maximal zulässigen Wert überschreitet oder der Absolutwert der Akkuspannung einen gewissen Minimalwert unterschreitet.

Zum Erkennen, ob die Akkus 1, 2 aus der elektronischen Einrichtung herausgenommen wurden, z.B. bei einem Akkutausch, weist die Vorrichtung ferner ein RC-Glied 12 auf, dessen Spannung durch eine mit Batt Out bezeichneten Einheit 13 überwacht wird. Durch das RC-Glied wird die Stromversorgung der elektronischen Einrichtung nicht sofort bei Herausnehmen der Akkus unterbrochen, sondern erst nach einer bestimmten, durch die Kapazität des Kondensators des RC-Gliedes 12 vorgegebenen Zeitspanne. Diese Zeitspanne kann zumindest zum Abspeichern aller wesentlichen Daten genutzt werden.

Für den Lade- bzw. Entladealgorithmus gemäß dem erfindungsgemäßen Verfahren sind in einem hiefür reservierten Teilabschnitt eines EEPROM's 14 des Mikrorechners eine Anzahl von Register für bestimmte Parameter des Algorithmus abgespeichert, nämlich je ein Register für eine Nennkapazität (NominalCapacity) 15, eine Maximalkapazität (MaxCapacity) 16, je ein Register für den Inhalt eines Zählers (C-Count) 17, eines weiteren Zählers (D-Count) 18 und ein Register für die Kapazität pro Zählschritt (Capacity per Count Slope) 19.

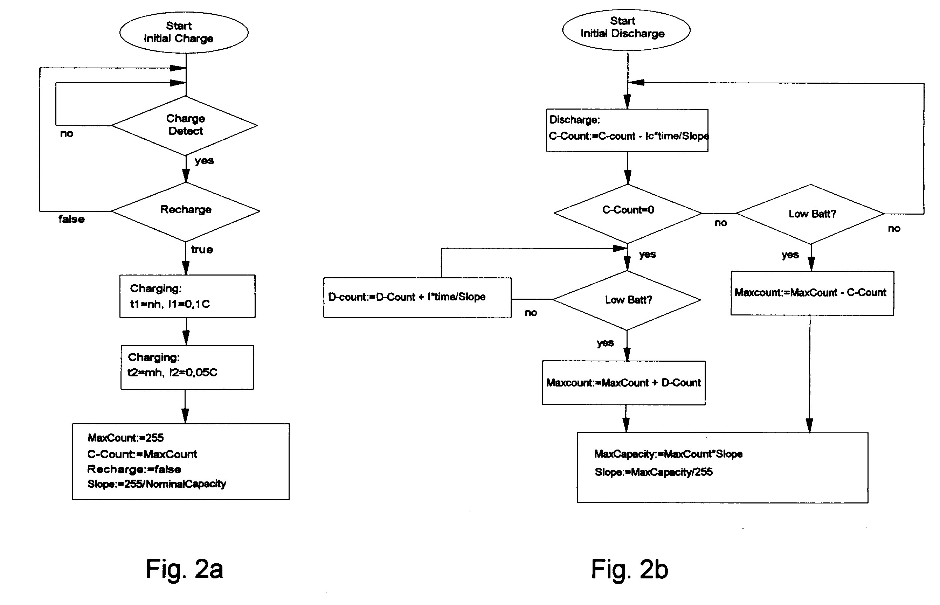

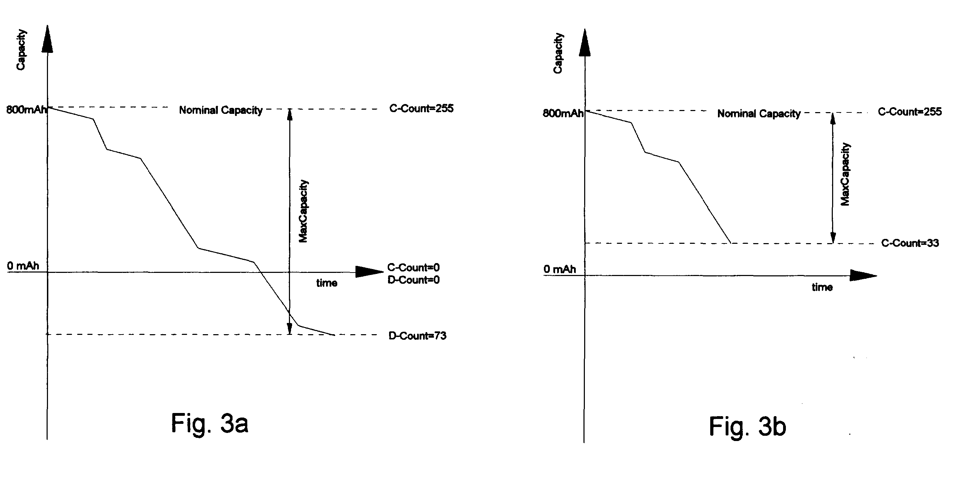

Die Bedeutung dieser Parameter für einzelne Schritte des Lade- bzw. Entladealgorithmus werden anhand der untenstehenden Beschreibung mit Bezug auf die Figuren 2a, 2b und 3a, 3b näher erläutert.

Grundsätzlich muß der Algorithmus entscheiden, ob es sich um eine erstmalige Ladung bzw. Entladung des Akkus handelt, da für eine solche erstmalige Ladung oder Entladung zur Bestimmung der Akkukapazität eine unterschiedliche Ablaufroutine vorgesehen ist, welche im folgenden mit Bezug auf die Figur 2a näher erläutert wird. Die Routine wird unabhängig von der Kapazität der vorhandenen Akkus unter Bezugnahme auf die gerätespezifische Nennkapazität NominalCapacity ausgeführt.

Beim erstmaligen Laden werden die Akkus 1, 2 in einem ersten Schritt für eine vorbestimmte Zeitdauer t1 mit einem vorbestimmten Strom I1 geladen. Für derzeit im Handel befindliche Akkus, z.B. zum Betreiben von Mobilfunktelefonen, deren Nennkapazität in einem Bereich zwischen ca. 600 und 1200 mAh beträgt, wird die Ladezeit t1 auf ca. 18 Stunden und der Ladestrom I1 auf ca. 0,1 C festgelegt, wobei C die Nennkapazität des Akkus in mAh ist, z.B. ergibt sich für einen Akku mit einer Nennkapazität NominalCapacity von 600mAh ein Ladestrom I1 von 60mA. Diese erste Ladephase soll sicherstellen, daß die Akkus 1, 2 ohne Kenntnis ihrer tatsächlichen Kapazität im wesentlichen vollgeladen sind. Die geringe Stromstärke von 0,1 C/s fügt einem Akku auch bei Überladen keinen Schaden zu. Demnach muß der Ladevorgang nicht auf Volladung des Akkus (ΔU ≠0) getestet werden bzw. bei Volladung unterbrochen werden.

Im nächsten Schritt werden die Akkus 1, 2 für eine weitere Zeitspanne t2 mit einem vergleichsweise geringeren Strom I2 geladen, um sicherzustellen, daß die Akkus auch unter Worst Case Bedingungen, z.B. bei hohen Ladetemperaturen, vollgeladen sind. Fur die oben angesprochenen Akkus 1, 2 zur Verwendung in Mobilfunktelefonen wird die Ladezeit t2 mit ca. 7,7 Stunden und der Ladestrom mit 0,05 C festgelegt. Bei einer solchen Stromstärke kann bei allen handelsüblichen Akkus davon ausgegangen werden, daß sie bei einem Überladen keinesfalls beschädigt werden.

Falls das elektronische Gerät nach der Initialladung nicht benutzt wird, erfolgt eine weitere Ladung der Akkus 1, 2 mit verringertem Strom, z.B. wie oben mit 0,05C, um Ladungsverluste auszugleichen und zu gewährleisten, daß der Akku bei Beginn des erstmaligen Entladens mit Sicherheit vollgeladen ist.

Nach Volladen des Akkus wird ein digitaler Zahler C-Count für die Kapazität des Akkus auf seinen Höchstwert gesetzt, z.B. bei einem 8-Bit Zähler auf C-Count = 255. Dieser Zählerhöchststand entspricht der Nennkapazität des Akkus, z.B. 800 mAh, sodaß bei einem nachfolgenden Entladen des Akkus durch den Betrieb der elektronischen Einrichtung bei einer entnommenen Ladungsmenge von je 3,14 mAh der Zähler um eins dekrementiert wird. Dieser Steigungsfaktor des Zählers ist in dem Capacity per Count Slope Register 19 des EEPROM's 14 gespeichert. Alternativ kann dieser Wert auch durch den Lade-/Entladealgorithmus selbst berechnet werden.

Beim erstmaligen Entladen der Akkus 1, 2 werden nun zur Bestimmung der tatsächlichen Kapazität durch den Algorithmus des Mikrorechners die im folgenden mit Bezug auf die Figur 2b näher erläuterten Schritte durchgeführt.

Der Zähler C-Count wird entsprechend dem Register 19 und dem jeweiligen Stromverbrauch der elektronischen Einrichtung dekrementiert. Der Stromverbrauch des elektronischen Gerätes kann beispielsweise durch Erfassung des Betriebszustandes der elektronischen Einrichtung durch den Mikrorechner und einer tabellarisch für alle möglichen Betriebszustände hinterlegten Stromverbrauchsinformation durch Aufsummieren des Stromverbrauchs über die Zeit ermittelt werden.

In dieser Phase wird ein Nachladen der Akkus bei Anschließen der elektronischen Einrichtung an die Ladestation durch den Algorithmus dadurch verhindert, daß der Halbleiterschalter 6 der Pulsweitenmodulation 5 während der gesamten Entladephase gesperrt wird.

Das erstmalige Entladen der Akkus 1, 2 wird bei entsprechender Dekrementierung des Zählers C-Count solange fortgeführt bis entweder der Zähler C-Count den Wert Null erreicht hat oder die Anzeige LowBatt 11 für den unteren Grenzwert der Akkuladung aktiviert wird. Beide Fälle werden im folgenden mit Bezug auf die Figuren 3a, 3b näher erläutert.

In Figur 3a ist jener Fall dargestellt, bei welchem der Zähler den Wert Null erreicht hat bevor der untere Grenzwert für die Akkuladung erreicht wurde, das heißt, daß die tatsächliche Akkukapazität größer als die gerätespezifisch voreingestellte Nennkapazität NominalCapacity ist. In diesem Fall wird der Entladevorgang fortgeführt und zur Bestimmung der entladenen Ladungsmenge ein weiterer Zähler D-Count gestartet, der entsprechend dem zeitlichen Stromverbrauch inkrementiert wird, bis die Anzeige LowBatt 11 für den unteren Grenzwert der Akkuladung aktiviert wird. Dem zweiten Zähler D-Count liegt üblicherweise dieselbe Steigung Capacity per Count Slope zugrunde.

Bei Erreichen des LowBatt - Zustandes kann nun durch Addieren des Höchststandes des ersten Zählers C-Count und des aktuellen Standes des zweiten Zählers D-Count und mit Hilfe des Registers 19 die tatsächlich dem Akku entnehmbare Ladungsmenge MaxCapacity ermittelt werden. Wenn bei einer Nennkapazität von NominalCapacity = 800mAh beispielsweise der Zähler D-Count den Wert 73 erreicht hat, beträgt die Gesamtkapazität der Akkus MaxCapacity = 1029mAh. Der dadurch ermittelte Wert wird in das Register 16 für die maximale Akkukapazität eingetragen. Um die Auflosung des Zählers C-Count voll nutzen zu können, wird nun der Wert für das Register 19 neu festgesetzt, z.B. bei dem 8-Bit Zähler und der oben ermittelten maximalen Akkukapazität auf 4,035mAh je Zählerschritt.

Wie ein Figur 3b zu sehen ist, kann es jedoch auch vorkommen, daß die Anzeige für den unteren Grenzwert der Akkuladung 11 aktiv wird, noch bevor der Zähler den Wert Null erreicht hat, das heißt, daß die tatsächliche Akkukapazität MaxCapacity geringer ist als die gerätespezifisch vorgegebene Nennkapazität NominalCapacity. Demnach wird zur Bestimmung der tatsächlichen Akkukapazität die dem verbleibenden Zählerstand C-Count entsprechende Ladungsmenge von der Nennkapazität der Akkus subtrahiert, z.B. wenn der verbleibende Zählerstand C-Count = 33 beträgt, ergibt sich die aktuelle maximale Kapazität des Akkus für den vorliegenden Fall (Nennkapazität 800mAh, 255 Zählerschritte) die aktuelle maximale Akkukapazität MaxCapacity = 696,5mAh. Nach der Bestimmung der aktuellen maximalen Akkukapazität wird wiederum, wie oben beschrieben, die Steigung des Zählers Slope neu festgelegt. Die neuen Werte für die maximale Akkukapazität und die Steigung des Zählers werden in die Register 16 bzw. 19 des EEPROM's 14 einprogrammiert.

Alle nachfolgenden Lade- und Entladevorgänge werden hingegen nach einem etwas geänderten Algorithmus ausgeführt, welcher im folgenden näher erläutert wird.

Beim Laden der Akkus 1, 2 wird der Zahler C-Count entsprechend des Ladestromes und der Ladezeit in Abhängigkeit von der Zählersteigung (Inhalt des Registers 19) inkrementiert, sodaß der Algorithmus ständig über die aktuelle Ladung der Akkus 1, 2 informiert ist. Bei einer Ladung des Akkus zwischen 0 und 95% beträgt der Ladestrom wiederum 0,1C, wogegen bei einer Ladung über 95% der Ladestrom auf 0,05C verringert wird, um eine Beschädigung der Akkus (vor allem der empfindlicheren NiMh-Akkus) zu vermeiden.

Beim Entladen der Akkus wird der Zähler C-Count entsprechend des Stromverbrauchs der elektronischen Einrichtung und der Betriebszeit in Abhängigkeit von der Zählersteigung (Register 19) dekrementiert, sodaß der Algorithmus wieder zu jedem Zeitpunkt über die aktuelle Ladung der Akkus (1, 2) informiert ist.

Falls während der Lebensdauer der Akkus Schwankungen in bezug auf die Gesamtkapazität der Akkus 1, 2 auftreten oder falls Toleranzabweichungen aufgrund der Auflösung des Zählers und Ungenauigkeiten in bezug auf die Zählersteigung auftreten, können diese Abweichungen durch den Algorithmus selbsttätig erkannt und korrigiert werden, nämlich immer dann, wenn der Zähler C-Count den Wert Null erreicht hat und die Anzeige LowBatt 11 für den unteren Grenzwert der Akkuladung noch nicht aktiviert ist, oder dann, wenn die Anzeige LowBatt 11 für den unteren Grenzwert der Akkuladung bereits aktiviert ist und der Zähler C-Count noch nicht den Wert Null erreicht hat. In diesen Fallen wird eine Neufestsetzung der aktuellen maximalen Akkukapazität MaxCapacity (Register 16) und der Steigung des Zählers Capacity per Count Slope (Register 19) gemäß dem weiter oben mit Bezug auf die Figuren 2b bzw. 3a und 3b erläuterten Algorithmus vorgenommen.

Um die Genauigkeit des Wertes für die maximale Akkukapazität MaxCapacity zu verbessern, kann weiters vorgesehen sein, daß ein initiales Laden und Entladen gemäß Figur 2 in gewissen Abständen, z.B. nach einer bestimmten Anzahl von Lade- und Entladevorgängen oder einer bestimmten Betriebsdauer oder auf Verlangen des Benutzers erneut vorgenommen wird. Weiters kann bei dem Algorithmus vorgesehen sein, daß eine initiale Lade- und Entladephase dann durchgeführt wird, wenn die Einheit 13 ein Entfernen, z.B. ein Austauschen der Akkus, angezeigt hat.

## Patentansprüche

1. Verfahren zum Laden bzw. Entladen eines Akkus (1, 2) mit im wesentlichen unbestimmter Bauart und/oder Kapazität für eine elektrische oder elektronische Einrichtung, bei welcher ein Mittel zum Anzeigen eines unteren Grenzwertes der Akkuladung (LowBatt) und ein Mittel (C-Count, D-Count) zum Bestimmen einer geladenen oder entladenen Ladungsmenge vorgesehen ist, wobei dem Verfahren eine Nennkapazität (NominalCapacity) des Akkus (1, 2) zugrunde gelegt ist**, dadurch gekennzeichnet, daß** das Verfahren die folgenden Schritte aufweist:
a) Laden des Akkus (1, 2) für eine vorbestimmte Zeitdauer (t1), nach welcher in Abhängigkeit von der Nennkapazität (NominalCapacity) und einem vorgegebenen Ladestrom (I1) der Akku (1, 2) im wesentlichen vollständig aufgeladen ist,
b) Nachladen des Akkus (1, 2) für eine bestimmte Zeitdauer (t2) mit einem gegebenenfalls verringerten Ladestrom (I2), bei welchem eine Zerstörung eines vollgeladenen Akkus (1, 2) vermieden und ein Volladen eines nicht gänzlich vollgeladenen Akkus (1, 2) sichergestellt wird,
c) Entladen des Akkus (1, 2) durch den Betrieb der elektrischen oder elektronischen Einrichtung unter Verhinderung eines Nachladens, bis der untere Grenzwert der Akkuladung (LowBatt) erreicht wird, wobei während dieses Entladens durch das Mittel zum Bestimmen der entladenen Ladungsmenge (C-Count, D-Count) jene Ladungsmenge bestimmt wird, welche aus dem Akku entnommen wurde,
d) Setzen des Wertes der aktuellen maximalen Akkukapazität (MaxCapacity) auf den durch das Mittel zum Bestimmen der entladenen Ladungsmenge (C-Count, D-Count) bestimmten Wert.

2. Verfahren nach Anspruch 1, **dadurch gekennzeichnet, daß** die Schritte a), b), c) und d) bei einem erstmaligen Laden bzw. Entladen des Akkus (1, 2) durchgeführt werden, **und daß** bei einem nachfolgenden Laden und Entladen des Akkus (1, 2) die geladene bzw. entladene Ladungsmenge durch das Mittel (C-Count, D-Count) zum Bestimmen der Ladungsmenge ermittelt und der aktuellen Ladungsmenge addiert bzw. subtrahiert wird, wobei für den Fall, daß bei Erreichen des unteren Grenzwertes (LowBatt) die durch das Mittel zum Bestimmen der entladenen Ladungsmenge ermittelte Summe bzw. Differenz ungleich Null ist, der Wert für die aktuelle maximale Akkukapazität (MaxCapacity) des Akkus (1, 2) entsprechend neu festgesetzt wird.

3. Verfahren nach Anspruch 1 oder 2, **dadurch gekennzeichnet**, **daß** das Mittel zum Bestimmen der geladenen bzw. entladenen Ladungsmenge (C-Count, D-Count) einen digitalen Zähler aufweist, welcher in zeitlichen Abständen in Abhängigkeit von dem Ladestrom bzw. dem Entladestrom inkrementiert oder dekrementiert wird.

4. Verfahren nach Anspruch 3, **dadurch gekennzeichnet**, **daß** der Entladestrom aus Betriebsparametern der elektrischen bzw. elektronischen Einrichtung und einer diesen Betriebsparametern zugeordneten Entladestrom-Tabelle ermittelt wird.

5. Verfahren nach Anspruch 1 oder 2 und 3 oder 4, **dadurch gekennzeichhet, daß** der Zähler (C-Count) bei erstmaligem Entladen des Akkus (1, 2)von einem der maximalen Akkukapazität (MaxCapacity) entsprechenden Zählerstand (MaxCount) und bei einem nachfolgendem Entladen von einem der aktuellen Aufladung entsprechenden Zählerstand (C-Count) dekrementiert wird, wobei für den Fall, daß der Zähler (C-Count) bei Erreichen des unteren Grenzwertes für die Akkuladung (LowBatt) noch nicht den Wert Null erreicht hat, die dem verbleibenden Zählerstand entsprechende Ladungsmenge von der maximalen Akkukapazität (MaxCapacity) subtrahiert und die resultierende Kapazität als aktuelle maximale Akkukapazität (MaxCapacity) neu festgelegt wird.

6. Verfahren nach Anspruch 1 oder 2 und Anspruch 3 oder 4, **dadurch gekennzeichnet**, **daß** der Zähler (C-Count) bei erstmaligem Entladen des Akkus (1, 2) von einem der maximalen Akkukapazität (MaxCapacity) entsprechenden Zählerstand (MaxCount) oder bei nachfolgendem Entladen von einem der aktuellen Aufladung entsprechenden Zählerstand (C-Count) dekrementiert wird, wobei für den Fall, daß der Zähler (C-Count) den Wert Null erreicht hat, bevor der untere Grenzwert für die Akkuladung (LowBatt) erreicht ist, ein zweiter Zähler (D-Count) gestartet wird, welcher in zeitlichen Abstanden in Abhängigkeit von der entladenen Ladungsmenge inkrementiert wird, bis der untere Grenzwert für die Akkuladung (LowBatt) erreicht wird, und die dem Zählerstand des zweiten Zahlers (D-Count) entsprechende Ladungsmenge zu der maximalen Akkukapazität (MaxCapacity) addiert und der resultierende Kapazitätswert als aktuelle maximale Akkukapazität (MaxCapacity) neu festgelegt wird.

7. Verfahren nach Anspruch 5 oder 6, **dadurch gekennzeichhet, daß** bei jeder Neufestsetzung der maximalen Akkukapazität (MaxCapacity), die für einen De- bzw. Inkrementierschritt des Zählers erforderliche Ladungsmenge (Capacity per Count Slope) in der Weise neu festgesetzt wird, daß die aktuelle maximale Akkukapazität (MaxCapacity) dem Höchststand (Maxcount) des Zählers entspricht.

8. Verfahren nach Anspruch 1, **dadurch gekennzeichnet**, **daß** für den Zeitraum nach Ausführen der Schritte a) und b) und vor Beginn des Schrittes c) ein Erhaltungsladen des Akkus (1, 2) zum Ausgleich seiner ständigen Ladungsverluste, z.B. durch Stand-By Betrieb, vorgenommen wird.

9. Verfahren nach Anspruch 2, **dadurch gekennzeichnet**, **daß** der Akku (1, 2) bei einer Ladung zwischen 0 und ca. 95% der maximalen Akkukapazität (MaxCapacity) mit einem Ladestrom (I1) geladen wird, welcher kleiner oder gleich 0,1C beträgt, wobei C die Kapazität des Akkus in Amperestunden [Ah] ist und der Ladestrom I1 in [A] ist.

10. Verfahren nach Anspruch 2, **dadurch gekennzeichnet, daß** der Akku bei einer Ladung über ca. 95 % der maximalen Akkukapazität (MaxCapacity) mit einem Ladestrom (I2) geladen wird, welcher kleiner oder gleich 0,05C beträgt, wobei C die Kapazität des Akkus in Amperestunden [Ah] ist und der Ladestrom (I2) in [A] angegeben ist.

11. Verfahren nach einem der Ansprüche 1 bis 10, **dadurch gekennzeichnet, daß** zum Feststellen der unteren Grenze für die Akkuladung (LowBatt) die zeitliche Änderung der am Akku anliegenden elektrischen Spannung (-dU/dt) und/oder die zeitliche Änderung dieser zeitlichen Änderung bestimmt und mit einem jeweils maximal zulässigen Wert verglichen wird.

12. Verfahren nach Anspruch 1, **dadurch gekennzeichnet, daß** die Verfahrensschritte a), b), c) und d) selbsttätig zur Bestimmung der maximalen Akkukapazität (MaxCapacity) nach einer bestimmten Anzahl von Aufladungen des Akkus (1, 2) oder in zeitlichen Abstanden wiederholt werden.

13. Verfahren nach Anspruch 1, **dadurch gekennzeichhet, daß** die Verfahrensschritte a), b), c) und d) nach einer Anforderung zur Bestimmung der maximalen Akkukapazität (MaxCapacity) durch den Benutzer durchgeführt wird.

14. Verfahren nach einem der vorigen Ansprüche**, dadurch gekennzeichnet, daß** der Akku aus einer Serienschaltung von zumindest zwei handelsüblichen Akkus (1, 2) mit gleichen oder unterschiedlichen Kapazitäten zusammengesetzt wird.

15. Vorrichtung zum Laden und Entladen zumindest eines Akkus (1, 2) mit im wesentlichen unbestimmter Bauart und/oder Kapazität für eine elektrische oder elektronische Einrichtung, bei welcher ein Mittel zum Anzeigen eines unteren Grenzwertes der Akkuladung (LowBatt) vorgesehen ist und die Kapazität des Akkus vorerst durch eine gerätespezifische Nennkapazität (NominalCapacity) festgelegt ist, **dadurch gekennzeichet, daß** Sie ein Mittel zum Laden des Akkus (1, 2) mit einem vorbestimmten Ladestrom (I1) für eine vorbestimmte Zeitdauer (t1), nach welcher in Abhängigkeit von der Nennkapazität und einem vorgegebenen Ladestrom der Akku im wesentlichen vollständig aufgeladen ist, ein Mittel zum Nachladen des Akkus (1, 2) mit einem vorbestimmten, gegebenenfalls verringerten Ladestrom (I2) für eine vorbestimmte Zeitdauer (t2), bei welchem eine Zerstörung eines vollgeladenen Akkus vermieden und ein Volladen eines nicht gänzlich vollgeladenen Akkus sichergestellt ist, ein Mittel zum Verhindern eines Nachladens des Akkus bei nachfolgendem Entladen des Akkus (1, 2) durch den Betrieb der elektrischen oder elektronischen Einrichtung bis auf den unteren Grenzwert für die Akkuladung (LowBatt), sowie ein Mittel zum Bestimmen der dabei entladenen Ladungsmenge (C-Count, D-Count) und ein Mittel zum Setzen eines Wertes für die aktuelle maximale Akkukapazität (Maximum Capacity) auf den durch das Mittel zum Bestimmen der entladenen Ladungsmenge (C-Count, D-Count) bestimmten Wert aufweist.

16. Vorrichtung nach Anspruch 15, **dadurch gekennzeichnet, daß** sie weiters ein Mittel (C-Count, D-Count) zum Bestimmen der bei Aufladung des Akkus geladenen Ladungsmenge aufweist, welches ein Mittel zur Bestimmung des Ladestromes und der Ladezeit umfaßt.

17. Vorrichtung nach Anspruch 15, **dadurch gekennzechnet, daß** das Mittel zum Bestimmen der bei Entladen des Akkus entladenen Ladungsmenge ein Mittel zum Erfassen des aktuellen Betriebszustandes, sowie des daraus resultierenden Stromverbrauchs und der Entladezeit umfaßt.

18. Vorrichtung nach Anspruch 16 und 17, **dadurch gekennzeichnet, daß** das Mittel zum Bestimmen der geladenen oder entladenen Ladungsmenge ein digitaler Zähler (C-Count, D-Count) ist, welcher in Abhängigkeit von einer vorbestimmten Ladungsmenge je Zählerschritt (Capacity per Count Slope) und in Abhängigkeit von der geladenen oder entladenen Ladungsmenge in zeitlichen Abständen inkrementiert bzw. dekrementiert wird, wobei die Ladungsmenge je Zählerschritt, die maximale Akkuladung (MaxCapacity) und der aktuelle Zählerstand (C-Count, D-Count) in je einem Register (16, 17, 18, 19) der Vorrichtung gespeichert sind.
